Europäisches Patentamt

European Patent Office

Office européen des brevets

(11) Veröffentlichungsnummer: **0 484 809 A2**

# (12) EUROPÄISCHE PATENTANMELDUNG

(21) Anmeldenummer: **91118473.7**

(51) Int. Cl.5: **C23C 14/28**, H01L 39/24

(22) Anmeldetag: **30.10.91**

(30) Priorität: **05.11.90 DE 4035073**

(43) Veröffentlichungstag der Anmeldung:
**13.05.92 Patentblatt 92/20**

(84) Benannte Vertragsstaaten:
**BE CH DE FR GB GR IT LI NL**

(71) Anmelder: **Battelle-Institut e.V.**
**Am Römerhof 35 Postfach 900 160**
**W-6000 Frankfurt/Main 90(DE)**

(72) Erfinder: **Stafast, Herbert, Dr.**
**Pfingstbornstrasse 89**
**W-6200 Wiesbaden(DE)**
Erfinder: **Reiland, Werner, Dr.**
**Mollerbachstrasse 10**
**W-6370 Oberursel 1(DE)**
Erfinder: **Diegel, Marco**
**Aulweg 58**
**W-6300 Giessen(DE)**
Erfinder: **Von der Burg, Erik**
**Am Höhenstrauch 17**
**W-6246 Glashütten(DE)**
Erfinder: **Grill, Wolfgang, Prof. Dr.**
**Burgweg 8**
**W-6240 Königstein(DE)**

(54) **Verfahren zur Schichtherstellung mittels Abscheidung, insbesondere aus Laser- oder Pseudofunken-Ablation.**

(57) Um das Schichtwachstum bei gepulsten Abscheidungsverfahren, insbesondere durch gepulste Laser- oder Pseudofunken-Ablation zu verbessern, werden Gaspulse (8) in Form von Überschallmolekülstrahlen (bzw. -Atomstrahlen) einer Länge von $1\mu$ bis 10 ms auf das Substrat (5), bzw. die Filmoberfläche gegeben. Die Gaspulse werden mit den Ablationspulsen (2) zeitlich so koordiniert, daß z.B. ein Gaspuls kurz nach den ablatierten Teilchen das Substrat erreicht. Aufgrund der gepulsten Gaszufuhr kann der Druck am Substrat kurzzeitig bedeutend höher als der maximal mögliche stationäre Hintergrunddruck sein, wodurch im Falle von Reaktivgas dessen Einbau deutlich verbessert wird. Zudem kann der stationäre Hintergrunddruck beim erfindungsgemäßen Verfahren viel kleiner sein als bei einer stationären Gaszufuhr, wodurch großflächige Substrate beschichtet werden können. Bei vielen Systemen läßt sich mit der Erfindung die Substrattemperatur deutlich absenken, wenn das Reaktivgas in aktivierter Form (als Ionen und/oder Radikale) pulsartig auf das Substrat geblasen wird.

FIG. 1

EP 0 484 809 A2

Die Erfindung betrifft ein Verfahren zur Schichtherstellung mittels gepulster Abscheidung. Seit einigen Jahren wird die gepulste Laserablation und seit kurzer Zeit die gepulste Pseudofunkenablation erfolgreich für die Herstellung (dünner) Schichten eingesetzt. Insbesondere bei der Herstellung von Schichten aus Metallegierungen oder Keramiken mit stark unterschiedlichen Dampfdrücken und/oder Schmelztemperaturen der einzelnen Komponenten haben sich diese Methoden bewährt, da die Filmstöchiometrien in der Regel mit den Targetstöchiometrien übereinstimmen und die Abscheidungsraten hoch sind.

Bei vielen Systemen muß reaktiv abgeschieden werden, d.h. nicht im Vakuum, sondern bei einem Hintergrunddruck von üblicherweise $10^{-2}$ bis $10^{+2}$ Pa. Der maximal mögliche Hintergrund(partial)druck hängt stark von der Abscheidungsmethode ab. Bei der Verdampfung muß er gering bleiben, damit die Teilchen das Substrat erreichen können, während er beim Zerstäuben oder bei der Ablation deutlich höher sein kann. Der Druck darf allerdings nicht zu hoch sein, da die Plasmawolke bei höheren Drücken kleiner wird. Insbesondere bei der Beschichtung von großflächigeren Substraten mit 30-50 mm Durchmesser muß der Druck bei der üblichen Zerstäubung oder Ablation klein sein. Dieser geringe Druck (in der Regel <10 Pa) führt häufig zu dem Nachteil, daß das Reaktivgas während der Abscheidung nicht mit der richtigen Stöchiometrie in die Schicht eingebaut wird. In diesem Fall muß eine Nachbehandlung erfolgen. Üblicherweise wird die Schicht hierzu für einige Zeit bei einer bestimmten, häufig niedrigen Substrattemperatur dem Reaktivgas ausgesetzt. Dies kann häufig in-situ geschehen.

Um das Schichtwachstum zu verbessern, wird ferner auch das Reaktivgas direkt und kontinuierlich auf das Substrat geblasen, wodurch lokal in Substratnähe ein höherer Druck erreicht wird als in der gesamten Bedampfungskammer. In der Regel wird hierbei noch keine nennenswerte Absenkung der Substrattemperatur erreicht, allerdings kann der zweite Schritt der (in-situ) Nachbehandlung verkürzt werden, da mehr Atome des Reaktivgases eingebaut werden.

Bei vielen Systemen könnte eine Absenkung der Abscheidungstemperatur erreicht werden, wenn man den Film bei hohen Drücken abscheiden könnte. Aus den oben genannten Gründen ist dies aber nicht möglich.

Eine deutliche Absenkung der Substrattemperatur erreicht man, wenn das Reaktivgas in aktivierter Form als Ion und/oder Radikal zur Verfügung gestellt wird. Im Falle des Hochtemperatur-Supraleiters $Y_1Ba_2Cu_3O_{7-x}$ konnte hierdurch die Substrattemperatur von ca. 700 - 800 °C auf ca. 650 - 700 °C gesenkt werden, wobei die gleiche c-Achsen-Orientierung und hohe kritische Stromdichte erhalten wurden wie bei den höheren Temperaturen. Bei den Hochtemperatur-Supraleitern ist Sauerstoff das einzubauende Reaktivgas, das üblicherweise mittels Entladungen (Gleichspannungs-, Hochfrequenz- und Mikrowellenentladung) oder durch UV-Licht-Bestrahlung aktiviert wird. Gelegentlich wird auch Ozon verwendet, das Sauerstoff-Radikale abspaltet. Der aktivierte Sauerstoff wird meistens auf das Substrat und bei Zerstäubungs- und Ablationssystemen manchmal auch in die Plasmawolke geblasen. Bislang konnte nicht gezeigt werden, daß das Hineinblasen in die Plasmawolke das Schichtwachstum verbessert, zumal die entscheidenden Prozesse für das Schichtwachstum ohnehin auf dem Substrat stattfinden.

Beim Hochtemperatur-Supraleiter $Y_1Ba_2Cu_3O_{7-x}$ werden die Schichten bei allen bislang bekannten Verfahren in einem Temperatur-Druck-Bereich abgeschieden, in dem die Schichten zwangsläufig einen zu geringen Sauerstoffanteil annehmen. Aufgrund des niedrigen Sauerstoffgehaltes sind sie tetragonal. Bei der Nachbehandlung wird weiterer Sauerstoff eingebaut, wobei die supraleitende orthorhombische Kristallstruktur entsteht. Dies geschieht beim langsamen Abkühlen oder kurzzeitigen Halten im Temperaturbereich von 400 - 500 °C bei erhöhtem Sauerstoffdruck (P > 100 mbar). Durch diesen zweiten Schritt der in-situ-Nachbehandlung werden Schichten mit hoher Sprungtemperatur, hohen kritischen Stromdichten, guter Texturierung und glatten Oberflächen gewonnen (sofern die Abscheidungsparameter stimmen). Unvermeidlich ist allerdings eine starke Zwillingsabscheidung aufgrund der Phasenänderung.

Aus dem Stand der Technik sind keine Lösungen für die oben geschilderte Problematik entnehmbar. So ist z.B. in der DE-OS 37 37 142 lediglich ein konventionelles Pseudofunken-Ablationsverfahren zur erfolgreichen Herstellung dünner Schichten beschrieben, bei dem hochschmelzende oder oxidische Materialien, insbesondere oxidkeramische Supraleiter, von entsprechenden Targets durch Pseudofunkenentladungen abgetragen werden, welche mittels aus einer Bohrung in der Anode austretenden Niederdruckgases gezündet wird. Irgendwelche weiteren Druckangaben oder auch Betrachtungen sind dieser Schrift nicht entnehmbar.

Die DE-PS 38 34 402 beschreibt ein Verfahren zur Beschichtung von beispielsweise $ZrO_2$-Substraten mit oxidkeramischen Supraleitern, die als Targets eingesetzt und mittels gepulster Teilchen- oder Laserstrahlablation aufgetragen werden. Für den Ablationsprozeß wird ein gepulster Elektronenstrahl aus einer Pseudofunkenkammer eingesetzt. Bei der Abscheidung auf Substrate bei Temperaturen von z.B. 820 °C werden etwaige Sauerstoffver-

luste durch $O_2$ als Betriebsgas mit einem stationären Partialdruck von 10 Pa teilweise ausgeglichen. Damit trifft die oben geschilderte Problematik der Einstellung eines optimalen Hintergrunddrucks auch in diesem Verfahren zu.

Aufgabe der Erfindung ist es, ein Verfahren zur Schichtherstellung mittels gepulster Abscheidung, insbesondere aus Laser- oder Pseudofunken-Ablation, anzugeben, bei dem das Schichtwachstum und/oder die Schichteigenschaften bei vorgegebenem Substrattemperaturbereich verbessert werden können und darüberhinaus, wenn dies angestrebt wird, eine deutliche Absenkung der Substrattemperatur möglich ist.

Diese Aufgabe wird erfindungsgemäß dadurch gelöst, daß die Gasteilchen der eingesetzten kurzen Gaspulse von 1 $\mu$s bis 10 ms Länge Energie an die gerade abgeschiedenen ablatierten Teilchen und/oder an die Schichtoberfläche gerade vor der Abscheidung der ablatierten Teilchen abgeben, oder alternativ dadurch, daß diese Energie den sich gerade abscheidenden ablatierten Teilchen verliehen wird. Insbesondere beruht die Erfindung auf der Abgabe von Energie an die ablatierten (abgetragenen) Teilchen, weshalb das erfindungsgemäße Verfahren auch mit Gaspulsen aus Inertgas das Schichtwachstum verbessert und/oder die Absenkung der Substrattemperatur ermöglicht. Die benötigte Energie für das Verfahren wird durch auf das Substrat gerichtete Überschall-Molekülstrahlen (bzw. -Atomstrahlen) erreicht, die die abgeschiedenen Teilchen anregen können, so daß diese zusätzliche Energie haben, ihren optimalen Platz im Kristallgitter zu finden.

Aus der US-PS 4 428 812 ist zwar ein Sputterverfahren bekannt, bei dem mit einem zeitlich modulierten Stickstoffhintergrunddruck gearbeitet wird, jedoch ist diese Gasdruckmodulation weder von ihrem Zweck noch ihrer Wirkung mit den erfindungsgemäßen Gaspulsen für die in Frage stehende gepulste Schichtabscheidung vergleichbar. So wird der modulierte Hintergrunddruck in Form eines Stickstoffrings mit einem Intervall von 0,2 bis 0,5 sec erzeugt, um so periodisch einen Gasraum zu schaffen, in dem die vom Target abgelösten Titanatome noch oberhalb des Substrats und vor der Abscheidung mit dem Stickstoffgas zu Titannitrid reagieren können, welches dann auf dem Substrat abgeschieden wird. Nur diese chemische Reaktion ist beabsichtigt. Hierauf ist auch die lange Periode (bis 0,5 sec) der Gaszufuhr eingerichtet, die bedingt, daß der Druck dann nicht größer als bei stationärer Zufuhr sein könnte, denn andernfalls würde eine Plasmawolke empfindlich gestört. Auch wird der Gasring weit entfernt vom Substrat erzeugt, um die chemische Reaktion vor Erreichen des Substrats zu gewährleisten, weshalb sich die Gasteilchen lediglich mit ihrer niedrigen thermischen Energie bewegen.

Demgegenüber können die erfindungsgemäßen Überschall-Molekülstrahlen bzw. -Atomstrahlen, die direkt auf die Substratoberfläche gerichtet sind, dort einen hohen Energieübertrag leisten. Die gepulste Zufuhr von Gasteilchen auf das Substrat und/oder in die Plasmawolke kann in bestehenden Systemen ohne weiteres angewandt werden. So sind bei der gepulsten Ablation die Ablationsimpulse zwischen 15 und 100 ns lang und die Lebensdauer der Plasmawolke beträgt maximal 1 ms. Bei den üblichen Wiederholfrequenzen von ca. 10 Hz erfolgt alle 100 ms ein Ablationsimpuls.

Erfindungsgemäß kann der Druck am Substrat kurzzeitig bedeutend höher als der maximal mögliche Hintergrunddruck sein, wodurch der Reaktivgaseinbau deutlich verbessert wird. Zudem kann der Hintergrunddruck sehr viel geringer sein als bei stationärer Gaszufuhr, was die Beschichtung großflächiger Substrate fördert. Bei aktivierter Form des Reaktivgases läßt sich erfindungsgemäß die Substrattemperatur um einen weiteren erheblichen Betrag absenken.

Eine erste erfindungsgemäße Lösung (Patentanspruch 1, wobei die Gaspulse das Substrat kurz nach den ablatierten Teilchen erreichen) der gestellten Aufgabe sieht vor, daß der Hintergrunddruck des Reaktivgases während des Laser- oder Pseudofunkenpulses gering ist, so daß sich eine Plasmawolke von z.B. 10 cm Länge ausbilden kann. Hierdurch lassen sich relativ große Substrate gleichmäßig beschichten. Um genügend Teilchen des Reaktivgases in die Schicht einbauen zu können, wird anschließend ein Puls des Reaktivgases auf das Substrat geblasen. Da die ablatierten Teilchen das Substrat schon erreicht haben, kann dieser Puls sehr viele Teilchen enthalten, so daß der Druck am Substrat kurzzeitig sehr hoch wird. Insbesondere sollte der erreichbare Maximaldruck >1 mbar vorzugsweise >10 mbar sein. Hierdurch werden viele der gerade abgeschiedenen Teilchen angeregt, so daß sie mehr Energie haben, ihren optimalen Platz im Kristallgitter zu finden.

Um die Substrattemperatur bei gleichbleibender Schichtqualität abzusenken, wird der Gaspuls in seiner Länge, Intensität und dem Zeitpunkt des Auftreffens am Substrat genau auf die zu bildende Schicht abgestimmt.

Bei manchen Systemen kann es für das Schichtwachstum vorteilhaft sein, wenn ein Gaspuls kurz vor den ablatierten Teilchen das Substrat erreicht, so daß die Schichtoberfläche durch Stöße angeregt wird. In der Regel wird ein Gaspuls vor dem Auftreffen der ablatierten Teilchen jedoch vor allem in Kombination mit einem nachfolgenden Gaspuls einen wesentlichen Vorteil bringen. Bei Systemen, die viele Teilchen des Reaktivgases einbauen müssen, kann es vorteilhaft sein, zwischen den Ablationspulsen mehrere Gaspulse auf das Substrat zu geben.

Eine zweite erfindungsgemäße Lösung der Aufgabe sieht vor, daß ein Gaspuls gleichzeitig mit den ablatierten Teilchen das Substrat erreicht. Damit auch bei dieser Lösung relativ großflächige Substrate beschichtet werden können, werden die Gaspulse in Substratnähe abgegeben, um die Plasmawolke nicht zu beeinträchtigen. Diese Lösung eignet sich für Systeme, bei denen die Gaspulse keine hohen Drücke am Substrat erzeugen müssen. Auch bei der Lösung können zwischen den Ablationspulsen weitere Gaspulse auf das Substrat gegeben werden. Diese Gaspulse können dann auch höhere Drücke erzeugen, als die gleichzeitig mit den ablatierten Teilchen das Substrat erreichenden Gaspulse.

Der Vorteil der beiden erfindungsgemäßen Lösungen gegenüber herkömmlichen Verfahren liegt darin, daß der Einbau des Reaktivgases und damit das Schichtwachstum aufgrund der kurzzeitig hohen Teilchendichte des Reaktivgases verbessert werden. Zudem wird hierdurch bei vielen Systemen die Substrattemperatur abgesenkt. Diese mögliche Absenkung ist zwar meistens gering (< 50 °C). Da jedoch zahlreiche Systeme bereits bei ausreichend niedrigen Temperaturen abgeschieden werden, ist das erfindungsgemäß erzielte verbesserte Schichtwachstum für diese Fälle mit oder ohne diese Absenkung bereits völlig zufriedenstellend.

Um bestimmte temperaturempfindliche Substrate verwenden zu können und eine stärkere Temperaturabsenkung zu erzielen, sieht die Erfindung die vorteilhafte Weiterbildung des Einsatzes von aktiviertem Reaktivgas vor. Durch die Zufuhr von aktivierten Teilchen (Ionen und/oder Radikalen) wird deren Einbau in die Schicht verbessert und gleichzeitig werden die an der Schichtoberfläche liegenden, bzw. gerade angekommenen Teilchen stark angeregt, so daß diese ihren Platz im Kristallgitter besser finden können. Durch diese Anregung der gerade abgeschiedenen Teilchen kann die thermische Anregung vom Substrat reduziert werden, und zwar erheblich stärker als es bei der früheren kontinuierlichen Zufuhr aktivierter Teilchen möglich war.

Bei geeigneter Auswahl und genügend hoher Teilchendichte der aktivierten Teilchen (Ionen und/oder Radikale), Gaspulslänge und Zeitpunkt des Auftreffens am Substrat läßt sich die Substrattemperatur beträchtlich absenken. Die Aktivierung kann über übliche Entladungen (Gleichspannungs-, Hochfrequenz- oder Mikrowellenentladungen), (UV-)Lichtbestrahlung oder über Funkenentladungen erfolgen. Die Aktivierungsart muß lediglich gewährleisten, daß ein hoher Anteil der gewünschten aktivierten Teilchen entsteht. Im Falle von Ionen können diese mittels elektrischer und/oder magnetischer Felder beschleunigt, abgebremst, fokussiert oder abgelenkt werden. Hierdurch läßt sich die örtliche Aktivierung der Schichtoberfläche gut steuern.

Anstelle des einzubauenden Reaktivgases kann auch ein Gas verwendet werden, das die einzubauenden Teilchen als Ion oder Radikal abspaltet, bzw. sich auch in diese zersetzt. Dies kann durch (UV-)Lichtbestrahlung oder mittels Entladungen verbessert werden. (Z.B. spaltet Ozon bei UV-Lichtbestrahlung Sauerstoffradikale ab).

Bei Systemen, bei denen kein Reaktivgas eingebaut werden muß, wird erfindungsgemäß das Schichtwachstum verbessert, indem Gaspulse inerter Gase (z.B. Argon oder Helium) pulsartig auf das Substrat gegeben werden. Bei sorgfältiger Wahl der Gaspulsparameter läßt sich zudem ein (unerwünschter) Einbau der Inertgasteilchen in die Schicht vermeiden.

Bevorzugtes Anwendungsgebiet der Erfindung ist die Herstellung von (dünnen) Schichten mit komplizierten Kristallstrukturen, die üblicherweise bei sehr hohen Substrattemperaturen abgeschieden werden müssen. Als Beispiel seien insbesondere die Hochtemperatur-Supraleiter erwähnt. Der Hochtemperatur-Supraleiter $Y_1Ba_2Cu_3O_{7-x}$ wird üblicherweise bei 700 - 800 °C, bei Zufuhr von aktiviertem Sauerstoff bei 650 - 700 °C abgeschieden (für Filme mit c-Achsen-Orientierung und hohen kritischen Stromdichten). Diese Temperaturen sind zu hoch, um interessante Substrate wie $Al_2O_2$ oder GaAs verwenden zu können, da entweder die Diffusion in den Film die Eigenschaften verschlechtert oder das Arsen abdampft. Der Einsatz von Pufferschichten (z.B. aus $Si_3N_4$, $SrTiO_3$ oder $ZrO_2$ kann nur zum Teil Abhilfe schaffen. Besser ist es, wenn die Substrattemperatur abgesenkt werden kann. Auch hier bietet der erfindungsgemäße Einsatz von Gasimpulsen aus aktivierten Teilchen eine vorteilhafte Lösung. Im Falle von $Y_1Ba_26u_3O_{7-x}$ hat diese Lösung den besonderen Vorteil, daß die Schichtbildung während der Dauer des Gaspulses in einem Temperatur-Druckbereich stattfindet, bei der sich die orthorhombische Phase bildet. D.h. die Phasenänderung tetragonal/orthorhombisch muß nicht mehr erfolgen, wodurch die Zwillungsbildung abnimmt. Bei längeren Gaspulsen von 1 ms und Maximaldrücken p > 100 mbar kann sogar die ortho-II-Phase (90K-Phase) direkt erreicht werden. Aber selbst bei Gaspulsen mit Maximaldrücken von ca. 10 mbar wird die ortho-I-Phase (60K-Phase) erreicht, so daß zumindest die Sauerstoffbeladungszeit nach der Abscheidung zum Erreichen der Ortho-II-Phase deutlich kürzer ausfällt. In der Regel reicht es auch, die Beschichtungskammer mit Sauerstoff zu fluten und den Film relativ schnell auf Raumtemperatur abzukühlen. Die niedrige Substrattemperatur von T < 550°C wird erst durch die zusätzliche Maßnahme des Einsatzes von Aktivteilchen erreicht. In diesem Temperaturbereich können die oben erwähnten Substrate direkt ($Al_2O_3$) bzw. mit Pufferschichten (Si, GaAs) verwendet werden, wobei die Schichtqualitäten denjenigen von Schichten auf üblichen Kristallsubstraten entsprechen. Direkt auf Silizium abgeschiedene Schichten haben allerdings etwas geringere Stromdichten als Schichten auf mit Pufferschichten versehenem Silizium.

Die Gaspulse können mit unterschiedlichen Anordnungen erzeugt und auf das Substrat geblasen werden. Am technisch einfachsten sind mit Ventilen versehene Düsen. Durch Steuerung der Ventilzeit werden die Pulslänge und der Pulszeitpunkt vorgegeben. Der Pulszeitpunkt wird z.B. über eine Triggerschaltung zeitlich mit den Ablationspulsen koordiniert. Über den Staudruck und die Düsenkonstruktion werden der maximale Druck am Substrat und die beschossene Fläche (abhängig vom Abstand Düse-Substrat) festgelegt. Bei großflächigen Substraten sind mehrere kleinere Düsen im allgemeinen einer großen vorzuziehen.

Die Aktivierung des Reaktivgases kann durch übliche Entladungen oder Lichtbestrahlung erfolgen. Je nach Art des Reaktivgases und der abzuscheidenden Schicht kann es vorteilhaft sein, die Aktivierungseinheit vor der Düse, in der Düse oder nach der Düse, vorzugsweise direkt nach deren Öffnung vorzusehen. Die Aktivierungseinheit kann aber auch unabhängig von der Düse sein und die ablatierten Teilchen in der Plasmawolke beispielsweise über ein Mikrowellenfeld mitaktivieren. Das Verfahren ist besonders erfolgreich, weil die Teilchen im Gaspuls auch ohne Beschleunigung der Ionen bereits eine hohe kinetische Energie haben. Aufgrund des hohen Staudruckes, des niedrigen Druckes in der Beschichtungskammer und der gepulsten Abgabe sind die Gaspulse Überschall-Molekülstrahlen (bzw. Überschall-Atomstrahlen). In der Beschichtungskammer kann unter Umständen auch eine leichte Clusterbildung einsetzen, die nicht stört.

Die Erfindung läßt sich bei der Herstellung von Schichten jeglicher Art mittels gepulster Abscheidungstechniken, insbesondere aus der gepulsten Laser- oder Pseudofunken-Ablation mit Erfolg anwenden. Durch Verwendung aktivierter Teilchen in den Gaspulsen wird bei vielen Systemen zudem die Substrattemperatur ohne Qualitätsminderung deutlich abgesenkt. Die Erfindung bietet sich besonders bei Schichtherstellung von Hochtemperatur-Supraleitern, Ferroelektrika oder Dielektrika an. Zu nennen sind insbesondere folgende Substanzen:

$ReBa_2Cu_3O_{7-x}$ (Re = Seltenerdelement oder Yttrium) Bleizirkonat (PZT), PZT mit Lanthan (PLZT), Bleititanat $ZrO_2$, $SrTiO_3$, $LaAlO_3$.

Im folgenden wir die Erfindung anhand von Zeichnungen beispielshalber erläutert. Dabei zeigen:

Fig. 1    die schematische Ansicht einer Vorrichtung zur Durchführung des erfindungsgemäßen Verfahrens und

Fig. 2    den zeitlichen Ablauf des Gasdrucks am Substrat für ein Ausführungsbeispiel des erfindungsgemäßen Verfahrens.

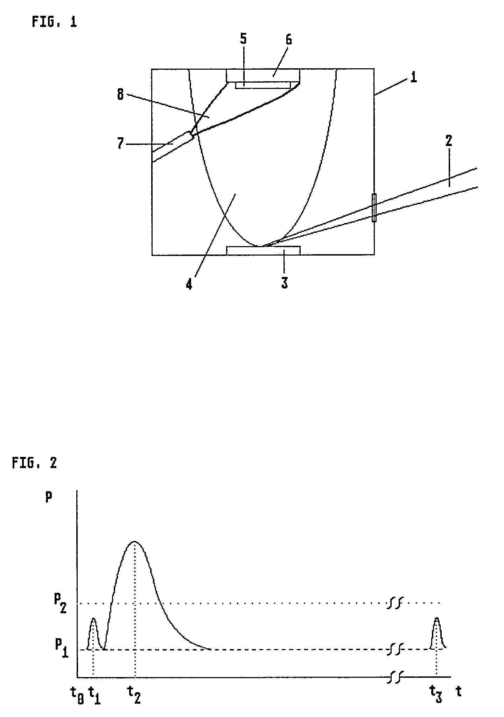

In einer Beschichtungskammer 1 (Fig. 1) wird mittels eines gepulsten Laserstrahls 2 auf ein Target 3 geschossen. Es bildet sich eine Plasmawolke 4 aus, durch die die Beschichtung eines Substrats 5 hervorgerufen wird. Das Substrat ist mit einer bei 6 angedeuteten Heizung heizbar. Über eine Düse 7 wird ein Gaspuls 8 auf das Substrat gegeben. Der Zeitpunkt des Gaspulses, seine Intensität und Dauer richten sich entsprechend der weiter oben genannten Kriterien nach der zu erstellenden Schicht. Der Gaspuls kann auch zum Großteil aus aktivierten Teilchen bestehen. Eine nicht dargestellte Aktivierungseinheit kann in der weiter oben genannten Art und Weise ausgelegt sein.

Fig. 2 zeigt den zeitlichen Verlauf des Druckes P am Substrat 5 bei einem erfindungsgemäßen Verfahren, bei dem die Düse 7 so gesteuert wird, daß ein kurzer Gasimpuls das Substrat 5 nach den ablatierten Teilchen erreicht. Zum Zeitpunkt $t_0$ liegt der niedrige Hintergrunddruck $P_1$ vor. Zum Zeitpunkt $t_1$ erreicht der Ablationspuls seinen Maximalwert, zum Zeitpunkt $t_2$ der Gaspuls, der das Substrat kurz nach den ablatierten Teilchen erreicht. Der erreichte Maximaldruck des Gaspulses ist deutlich höher als der maximal zulässige stationäre Hintergrunddruck $P_2$. Auch geht aus dem Verlauf hervor, daß der Druck nach dem Gaspuls wieder rasch auf den Druck $P_1$ abfällt. Zur Zeit $t_3$ erfolgt ein weiterer Ablationspuls, womit der Druckverlauf sich wiederholt.

## Patentansprüche

1.    Verfahren zur Schichtherstellung mittels gepulster Abscheidung, insbesondere aus Laser- oder Pseudofunken-Ablation,
dadurch gekennzeichnet,
daß ein oder mehrere Gaspulse einer Länge von 1 $\mu$s bis 10 ms als Überschall-Molekülstrahlen (bzw. -Atomstrahlen) zeitlich so gesteuert, daß sie gerade vor und/oder gerade nach den ablatierten Teilchen das Substrat erreichen, und diesen dort zusätzliche Energie zur Auffindung der Kristallgitterplätze verleihen, auf das Substrat gerichtet werden.

2. Verfahren zur Schichtherstellung mittels gepulster Abscheidung, insbesondere aus Laser- oder Pseudofunken-Ablation,
dadurch gekennzeichnet,
daß ein oder mehrere Gaspulse einer Länge von 1 $\mu$s bis 10 ms als Überschall-Molekülstrahlen (bzw. -Atomstrahlen) zeitlich so gesteuert, daß sie das Substrat gerade während der Abscheidung der kurz zuvor ablatierten Teilchen erreichen und diesen dort zusätzliche Energie zur Auffindung der Kristallgitterplätze verleihen, auf das Substrat gerichtet werden.

3. Verfahren nach Anspruch 2,
dadurch gekennzeichnet,
daß die Gaspulse insbesondere bei großflächigeren Substraten in Substratnähe erzeugt werden.

4. Verfahren nach einem der Ansprüche 1 bis 3,
dadurch gekennzeichnet,
daß weitere Gaspulse zeitlich so gesteuert, daß sie das Substrat zwischen den Ablationspulsen erreichen, erzeugt werden.

5. Verfahren nach einem der vorstehenden Ansprüche,
dadurch gekennzeichnet,
daß Gaspulse aus inerten Teilchen erzeugt werden.

6. Verfahren nach einem der vorstehenden Ansprüche,
dadurch gekennzeichnet,
daß Gaspulse, die aus Teilchen bestehen, welche in der herzustellenden Schicht einzubauende Atome oder Moleküle abspalten oder sich teilweise in solche zersetzen, erzeugt werden.

7. Verfahren nach Anspruch 6,
dadurch gekennzeichnet,
daß Gaspulse, die aus Teilchen bestehen, welche in der herzustellenden Schicht einzubauende Atome oder Moleküle abspalten oder sich teilweise in solche zersetzen, erzeugt werden.

8. Verfahren nach Anspruch 6 oder 7,
dadurch gekennzeichnet,
daß Gaspulse mit einem hohen Anteil an aktivierten Teilchen in Form von Ionen und/oder Radikalen erzeugt werden.

9. Verfahren nach Anspruch 8,
dadurch gekennzeichnet,
daß die Ionen mittels elektrischer und/oder magnetischer Felder beschleunigt und/oder gebremst werden.

10. Verfahren anch einem der vorstehenden Ansprüche,
dadurch gekennzeichnet,
daß die Gaspulse mit einem solchen Druck, daß sie für kurze Zeit am Substrat einen Gasdruck P > 1 mbar hervorrufen, erzeugt werden.

11. Verfahren nach einem der Ansprüche 1 bis 9,
dadurch gekennzeichnet,
daß die Gaspulse mit einem solchen Druck, daß sie für kurze Zeit am Substrat einen Gasdruck P > 10 mbar hervorrufen, erzeugt werden.

12. Verfahren nach einem der vorstehenden Ansprüche,
dadurch gekennzeichnet,
daß der Hintergrunddruck in der Beschichtungskammer in der Zeit, während der kein Gaspuls erzeugt wird, auf Werte < 0,2 mbar eingestellt wird.

13. Verfahren nach einem der vorstehenden Ansprüche,
dadurch gekennzeichnet,
daß der Hintergrunddruck in der Beschichtungskammer in der Zeit, während der kein Gaspuls erzeugt wird, auf Werte < 0,02 mbar eingestellt wird.

14. Verfahren nach einem der vorstehenden Ansprüche,
dadurch gekennzeichnet,
daß Schichten aus Metallegierungen oder Keramiken hergestellt werden.

15. Verfahren nach einem der vorstehenden Ansprüche,
dadurch gekennzeichnet,
daß Schichten aus Hochtemperatur-Supraleitern, insbesondere aus $Y_1Ba_2Cu_3O_{7-x}$ hergestellt werden.

16. Verfahren nach Anspruch 15,
dadurch gekennzeichnet,
daß die Substrattemperatur auf < 600 °C, insbesondere < 500 °C eingestellt wird.

**17.** Verfahren nach einem der vorstehenden Ansprüche,
dadurch gekennzeichnet,
daß die Gaspulse mit einer Länge zwischen 100 $\mu$s und 1 ms erzeugt werden.

**18.** Verfahren nach einem der vorstehenden Ansprüche,
dadurch gekennzeichnet,
daß die Gaspulse über mindestens eine Düse auf das Substrat gegeben werden.

**19.** Verfahren nach einem der vorstehenden Ansprüche,
dadurch gekennzeichnet,
daß die Gasteilchen an den Düsen aktiviert werden.

FIG. 1

FIG. 2